Europäisches Patentamt

(19) European Patent Office

Office européen des brevets

(11) Veröffentlichungsnummer : **0 046 317**
**B1**

(12) EUROPÄISCHE PATENTSCHRIFT

(45) Veröffentlichungstag der Patentschrift :
30.01.85

(51) Int. Cl.⁴ : **H 02 H   3/38**, G 01 R 31/08

(21) Anmeldenummer : 81200845.6

(22) Anmeldetag : 23.07.81

(54) Verfahren und Einrichtung zur Kurzschluss-Richtungsdetektion.

(30) Priorität : 15.08.80 CH 6167/80

(43) Veröffentlichungstag der Anmeldung :
24.02.82 Patentblatt 82/08

(45) Bekanntmachung des Hinweises auf die Patenterteilung : 30.01.85 Patentblatt 85/05

(84) Benannte Vertragsstaaten :
CH DE LI SE

(56) Entgegenhaltungen :
FR-A- 2 380 631
US-A- 4 187 461
IEE PROCEEDINGS-C, Band 127, Nr. 4, Juli 1980,
Seiten 228-239 Stevenage, G.B. A.T. JOHNS: "New
ultra-high-speed directional comparison technique
for the protection of e.h.v. transmission lines"
ASEA JOURNAL, Band 45, Nr. 3, 1972, Seiten 87-90
Västeras, SE. C.-H. EINVALL: "Directional relay type
RXPE 4"

(73) Patentinhaber : BBC Aktiengesellschaft Brown,
Boveri & Cie.
Haselstrasse
CH-5401 Baden (CH)

(72) Erfinder : Vitins, Michael, Dr.
Meierwiesenstrasse 36/23
CH-8064 Zürich (CH)

**Beschreibung**

Die Erfindung bezieht sich auf Verfahren und eine Einrichtung zur Kurzschluss-Richtungsdetektion an elektrischen Einrichtungen, insbesondere elektrischen Leitungen und Stromversorgungs-Netzen, nach den Oberbegriffen der Ansprüche 1, 2 und 3.

Mit diesen Oberbegriffen nimmt die Erfindung auf einen Stand der Technik von Verfahren und Einrichtungen zur Kurzschluss-Richtungsdetektion Bezug, wie er in der FR-A-2 380 631 beschrieben ist. Dort wird durch einen Phasenwinkelvergleich von Strom- und Spannungsdifferenzsignalen, die von zu überwachenden Stromversorgungsleitungen abgeleitet sind, ein Fehlerrichtungskriterium bezüglich des Messortes erzeugt. Diese Differenzsignale werden mittels Speichergliedern, z. B. hinsichtlich Amplitude und Phase abgestimmten Oszillatoren, gebildet, welche vom Ausgangssignal eines Fehlerdetektors (Impedanzrelais) gesteuert werden. Dieses Fehlerdetektor-Ausgangssignal bewirkt auch die Freigabe des Fehler-Richtungssignals. Eine Speicherung in den Speichergliedern beginnt erst nach einer Zeitdauer $\Delta T_2$ nach Fehlereintritt, d. h. nachdem der Fehlerdetektor angesprochen hat. Danach vergeht nochmals eine Zeitdauer $\Delta T_1$ bis ein Fehler-Richtungssignal zur Verfügung steht.

Aufgabe der Erfindung ist es, die Zeitdauer für eine Kurzschluss-Richtungsdetektion zu verkürzen und gleichzeitig eine hohe Zuverlässigkeit der Detektion zu gewährleisten.

Diese Aufgabe wird gemäss den Merkmalen der Ansprüche 1, 2 und 3 gelöst. Eine Weiterbildung der Erfindung ist im abhängigen Anspruch 4 beschrieben.

Ein Vorteil der Erfindung besteht darin, dass die auswertbaren Vorzeichen der Differenzsignale vergleichsweise rasch zur Verfügung stehen und damit ein schnelles und selektives Auslösen von Schutzeinrichtungen bzw. Stromabschaltungen der vom Kurzschluss betroffenen Leitungen ermöglichen.

Zum einschlägigen Stand der Technik wird zusätzlich auf IEE Proceedings Band 127, Nr. 4, Juli 1980, S. 228-239, insbesondere Fig. 6a, verwiesen. Dort wird ein Spannungsbezugssignal aus dem Zeitverlauf des Spannungssignals durch eine vorgebbare Zeitverzögerung abgeleitet, die ein ganzzahliges Vielfaches der Grundperiode ist.

Weitere Verfahren und Einrichtungen zur Kurzschluss-Richtungsdetektion mit Vorzeichen- oder Phasenwinkelvergleich von Strom- und Spannungssignalen sind bekannt aus dem Buch von Leonhard Müller, Selektivschutz elektrischer Anlagen, 1971, Verlags- und Wirtschaftsgesellschaft der Elektrizitätswerke mbH., Frankfurt/Main, S. 58 ff. Diese bekannten Verfahren arbeiten im wesentlichen mit der Grundschwingung von Strom- und Spannung und erfordern daher im Hinblick auf die Ausgleichsvorgänge bei einem Kurzschluss umfangreiche Filter sowohl für den Strom- wie auch für den Spannungs-Messkanal. Eine zuverlässige Vorzeichen- bzw. Phasenwinkelauswertung der Strom- und Spannungssignale zur Fehlerrichtungsdetektion ist daher erst nach Einschwingen der Filter mit entsprechender Verzögerung möglich. Auch begrenzt die Phasenwinkelauswertung — etwa durch Auswertung von Spannungs-Nulldurchgängen — die Ansprechzeit eines Kurzschluss-Richtungsdetektors nach unten auf mindestens eine Halbperiode der Grundschwingung.

Die Erfindung wird nachstehend anhand der in den Zeichnungen dargestellten Ausführungsbeispiele erläutert. Hierin zeigt :

Figur 1 das Prinzipschaltbild einer ersten Ausführung einer Schaltung zur Kurzschluss-Richtungsdetektion mit Strom- und Spannungs-Differenzsignalen,

Figur 2 ein Strom-Zeitdiagramm zur Differenzsignalbildung in der Schaltung nach Fig. 1, mit Kurzschluss bei K,

Figur 3 eine Abwandlung der Schaltung nach Fig. 1 mit dynamischen Speicherschaltungen im Strom- und Spannungs-Messkanal,

Figur 4 ein Strom- und Spannungs-Zeitdiagramm zu der Schaltung nach Fig. 3, ebenfalls mit Kurzschluss bei K, und

Figur 5 eine Abwandlung der Auswerteschaltung innerhalb der Schaltungsanordnung nach Fig. 1.

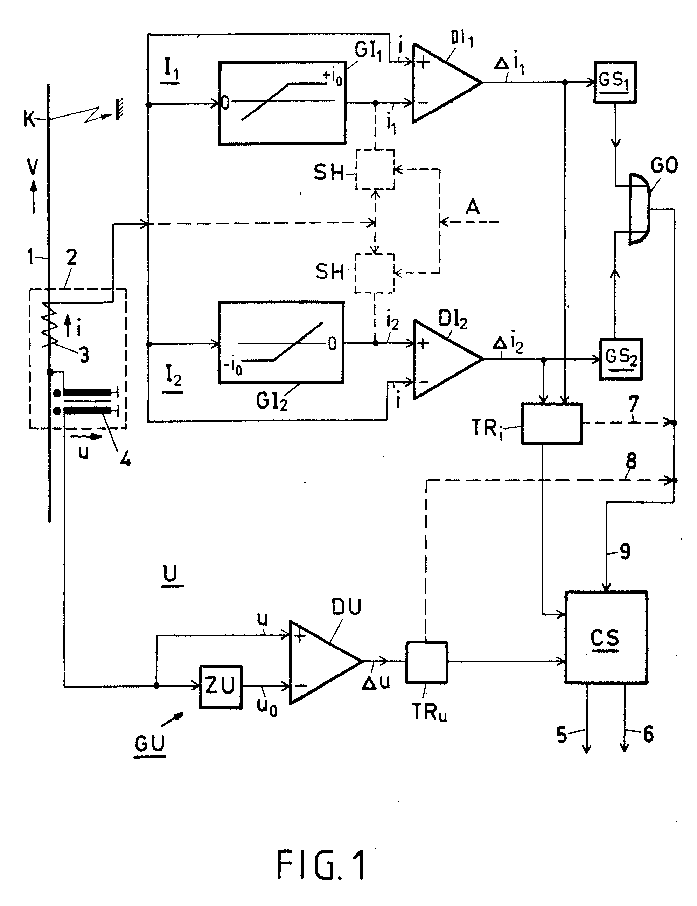

Gemäss Fig. 1 ist in einer auf einen Kurzschluss zu überwachenden Stromversorgungsleitung 1 eine Messstelle 2 mit einem Stromwandler 3 und einem Spannungswandler 4 vorgesehen. K bezeichnet eine Kurzschlussstelle in einer vorgebbaren Vorwärtsrichtung V der Stromversorgungsleitung 1. Das von dem Stromwandler 3 abgeleitete und dem Strom in der Stromversorgungsleitung 1 proportionale Strom-Messsignal i wird einem Strom-Messkanal mit zwei Teilkanälen $I_1$ und $I_2$ für die beiden Halbschwingungen entgegengesetzten Vorzeichens zugeführt. Das von dem Spannungswandler 4 abgeleitete und der Spannung in der Stromversorgungsleitung 1 proportionale Spannungs-Messsignal u wird einem Spannungs-Messkanal U zugeführt. In den beiden Teilkanälen $I_1$ und $I_2$ ist je ein Differenzsignalbildner $DI_1$ bzw. $DI_2$ angeordnet, der aus der betreffenden Halbschwingung des Strom-Messsignals i einerseits und Strom-Messsignalen $i_1$ bzw. $i_2$ andererseits, die auf einen vorgebbaren Strom-Grenzwert bzw. auf ein Strom-Bezugssignal $+ i_0$ bzw. $- i_0$ begrenzt sind, ein Strom-Differenzsignal $\Delta i_1$ und $\Delta i_2$ bildet. Diese beiden, den Halbschwingungen des Stromes zugeordneten Strom-Differenzsignale $\Delta i_1$ und $\Delta i_2$ werden einem Vorzeichendetektor üblicher Art, z. B. einem bistabilen Vibrator (Flipflop) bzw. einem bipolaren Trigger $TR_i$ zugeführt, der ausgangsseitig ein binäres Signal entsprechend dem jeweiligen Vorzeichen des Strom-Differenzsignals liefert. Die Strom-Grenzwerte für die Strom-Messsignale $i_1$ bzw. $i_2$ werden in

den Teilkanälen $I_1$ und $I_2$ mittels Bezugssignalgebern $GI_1$ bzw. $GI_2$ gebildet, die als Messwert-Begrenzer ausgebildet sind. Für das Strom-Messsignal $i_1$ von $GI_1$ gilt :

$$i_1 = i \text{ für } i \leqslant i_0.$$
$$i_1 = i_0 \text{ für } i > i_0.$$

Für das Strom-Messsignal $i_2$ von $GI_2$ gilt :

$$i_2 = i \quad \text{für } i \geqslant -i_0 \text{ und}$$
$$i_2 = i_0 \text{ für } i < -i_0$$

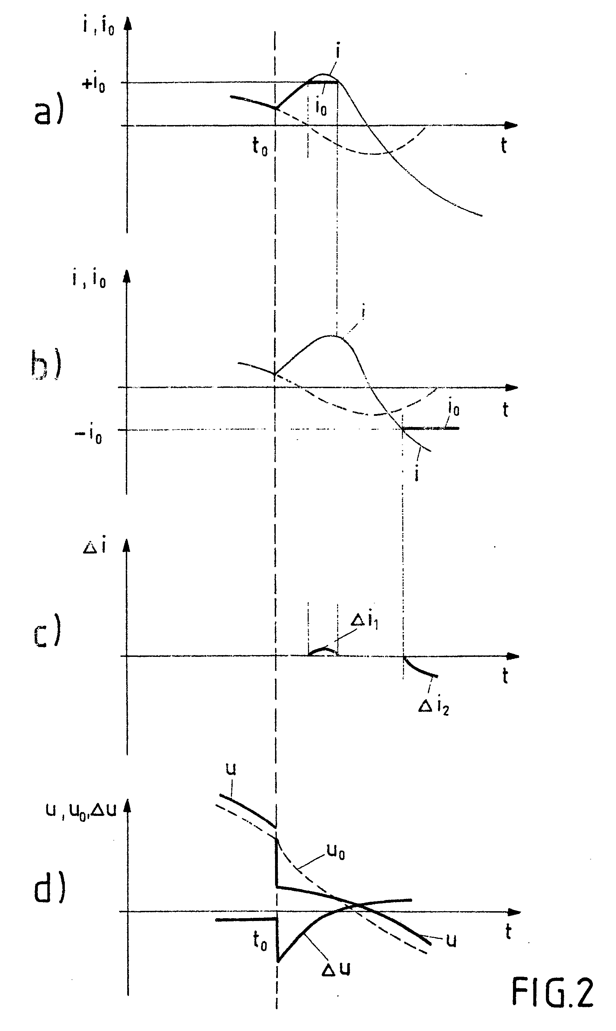

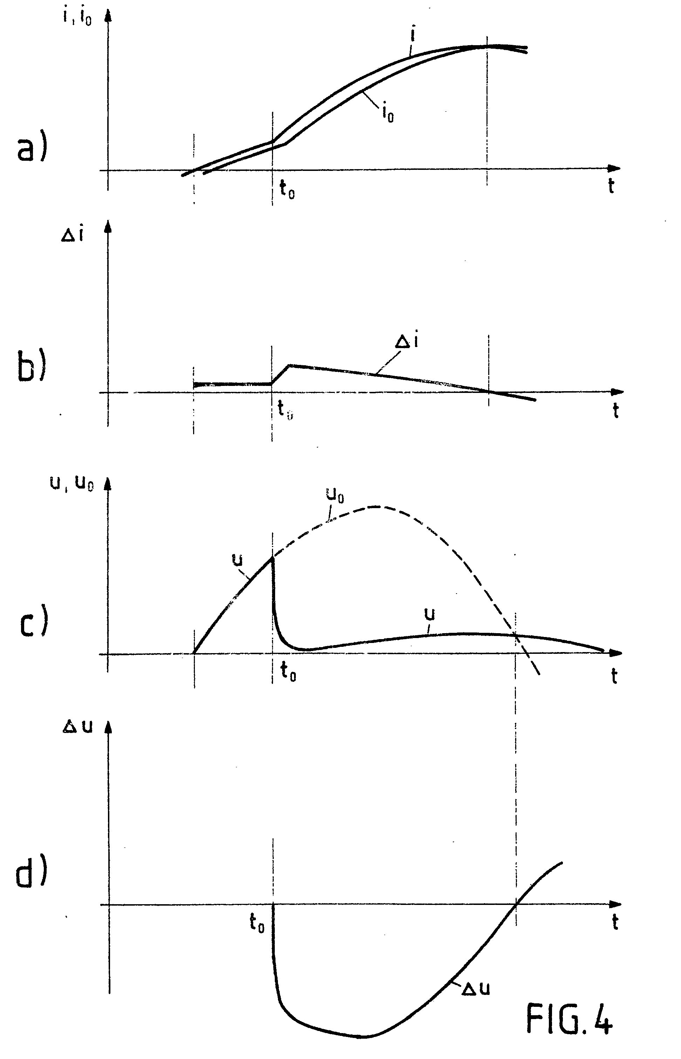

Wie aus Fig. 2 hervorgeht, bleibt das Ausgangssignal der Differenzsignalbildner $DI_1$ (Fig. 2a) bzw. $DI_2$ (Fig. 2b) Null, solange $+ i_0$ bzw. $- i_0$ durch i nicht über- bzw. unterschritten wird. Der Betrag des Strom-Grenzwertes $i_0$ stellt also einen Grenzwert dar, der einem Ueberstrom-Anregekriterium entspricht. Fig. 2c zeigt die den Grenzwertüberschreitungen in Fig. 2a und 2b entsprechenden Strom-Differenzsignale $\triangle i_1$ und $\triangle i_2$. Fig. 2d zeigt entsprechende Signale für die Spannung bei einem Kurzschluss in der Kurzschlussstelle K im Zeitpunkt t0 in Vorwärtsrichtung V bezüglich der Messstelle.

Grundsätzlich kann auch mit einer anderen Anregung des Kurzschluss-Richtungsdetektors gearbeitet und ein entsprechendes Stromsignal vor Fehlereintritt oder bei einem ersten Anzeichen für einen Kurzschluss als Strom-Bezugssignal $i_0$ verwendet sowie gespeichert werden, $i_0$ ist dann keine Konstante, sondern eine Funktion des Strommesssignals $i_0$. Eine solche Variante ist in Fig. 1 gestrichelt angedeutet. Die Gewinnung eines Strom-Grenzwertes $i_0$ erfolgt dabei kurz vor Fehlereintritt in Abhängigkeit von einem Fehler-Anregesignal, z. B. in Abhängigkeit von einer Grenzwertüberschreitung eines Stromanstiegs- bzw. eines di/dt-Signals. Der Anregekanal ist in Fig. 1 mit A bezeichnet, während die zugehörigen Abtast- und Speicherschaltungen an sich üblicher Art (vgl. z. B. DE-B- 2 406 196) mit SH bezeichnet sind. Letztere liefern wiederum die Werte $+ i_0$ und $- i_0$ für das Stromgrenzwertsignal, jedoch nun nicht mehr als fest vorgegebene Strom-Grenzwerte, sondern als Augenblickswerte des Strom-Messsignals kurz vor oder bei Fehlereintritt. Die anschliessende Signalverarbeitung und Auswertung unterscheidet sich nicht von der ersten Variante, jedoch wird eine bessere Anpassung der Richtungsdetektion an die jeweiligen Kurzschlussverhältnisse im Vergleich zu starren Strom-Grenzwerten erreicht.

Zusätzlich kann, wie in Fig. 1 angedeutet, ein Freigabekriterium für die Richtungsdetektion in Form einer Grenzwertüberwachung von $\triangle i_1$ und $\triangle i_2$ mittels entsprechender Grenzwertschalter $GS_1$ und $GS_2$ und eines nachgeschalteten ODER-Gliedes GO zur Freigabe bzw. Sperrung einer Vorzeichenvergleichsschaltung CS vorgesehen werden. Diese Grenzwertschalter liefern z. B. nur dann ein Ausgangssignal über die Leitung 9 wenn vorgebbare Grenzwerte überschritten sind. Die Vorzeichenvergleichsschaltung weist. z. B. ein an sich bekanntes und deshalb nicht dargestelltes Aequivalenzglied in Reihe mit einem Freigabeschalter auf. Damit lässt sich eine engere Fehlerselektion erreichen.

Die Schaltung nach Fig. 1 umfasst ferner innerhalb des Spannungs-Messkanals U einen Bezugssignalgeber GU mit einer Verzögerungsschaltung ZU für die Bildung eines Spannungs-Bezugssignals $u_0 = u(t - \tau)$ für die anschliessende Erzeugung eines Spannungs-Differenzsignals $\triangle u = u - u_0$ in einem entsprechenden Differenzsignalbildner DU. Dabei bedeuten t die Zeit und $\tau$ eine vorgebbare Verzögerungszeitdauer von z. B. 4 ms, vorzugsweise von weniger als einer halben Periodendauer der Netzfrequenz. Das Ausgangssignal des Differenzsignalbildners DU gelangt über einen Vorzeichendetektor in Form eines Triggers $TR_u$, z. B. einer Schaltung zur Realisierung der Signumfunktion, zusammen mit dem entsprechenden binären Signal vom Trigger $TR_i$ zur Vorzeichenvergleichsschaltung CS. Diese liefert z. B. an zwei je einer Fehlerrichtung bezüglich des Messortes zugeordneten Ausgängen bei Vorzeichnübereinstimmung bzw. Vorzeichenverschiedenheit selektive Fehlerrichtungssignale. Ein Signal z. B. am Ausgang 5 der Vorzeichenvergleichsschaltung CS bei unterschiedlichem Vorzeichen der Signale $\triangle i$ und $\triangle u$ entspricht einem Kurzschluss in Vorwärtsrichtung V bezüglich der Messstelle 2 entsprechend den eingezeichneten Pfeilrichtungen von i und u. Ein Signal am Ausgang 6 der Vorzeichenvergleichsschaltung CS bei gleichem Vorzeichen von $\triangle i$ und $\triangle u$ entspricht einem Kurzschluss in Rückwärtsrichtung, d. h. einem Kurzschluss in Gegenrichtung von V. Eine Umkehrung der Strom- und Spannungsrichtung am Stromwandler 3 und Spannungswandler 4 hat keinen Einfluss auf die Ausgangssignale an den Ausgängen 5 und 6. Wird nur eine dieser beiden Grössen umgepolt, so sind auch die Ausgänge der Vorzeichenvergleichsschaltung CS zu vertauschen.

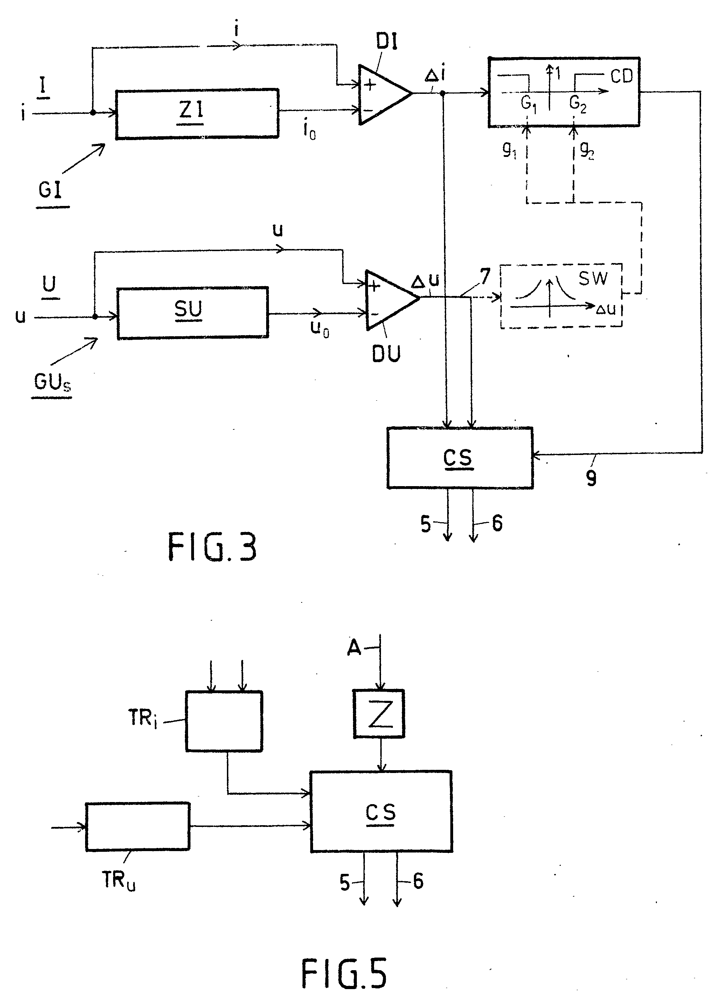

Bei der Schaltung nach Fig. 3 ist nur ein einfacher Strom-Messkanal I mit einem Bezugssignalgeber GI in Form einer Verzögerungsschaltung ZI als dynamische Speicherschaltung vorgesehen. Dem nachfolgenden Differenzsignalbildner DI wird das unverzögerte Strom-Messsignal i und das in ZI verzögerte Strom-Messsignal als Strom-Bezugssignal $i_0$ zugeführt. Die Verzögerungszeit von ZI kann vergleichsweise gering bemessen sein, vorzugsweise geringer als eine Grundschwingungs-Halbperiode, zum Beispiel unter 3 ms, da es im wesentlichen nur auf die Erzeugung eines Differenzsignals ankommt, das mit seinem Vorzeichen die jeweilige Aenderungsrichtung des Stromes anzeigt, und zwar in möglichst kurzer Zeit nach Fehlereintritt. Die untere Grenze der Verzögerungszeit ist dabei praktisch nur durch den Störpegel des Strom-Messsignals bestimmt, der eine sichere Vorzeichendetektion nicht beeinträchtigen soll. Diese Ausführung eignet sich auch für eine laufende Ueberwachung der Messsignale, gegebenenfalls unabhängig von einer gesonderten Fehleranregung, wobei laufend die relevante Vorzeicheninformation des Stromes bzw. der Stromänderung anfällt. Die genannte Stromverzögerung bei der Bildung von $i_0$ stellt übrigens keine Detektionsverzögerung dar, weil eine kurzschlussbedingte, z. B. sprungartige Stromänderung sofort in das Strom-Differenzsignal eingeht und dessen Vorzeichen bestimmt.

Das Spannungs-Bezugssignal $u_0$ kann grundsätzlich in gleicher Weise wie bei der Schaltung nach Fig. 1 mittels Verzögerung gebildet werden. Im Beispiel nach Fig. 3 ist für den Spannungs-Bezugs-signalgeber $GU_s$ ein auf die Grundschwingung abgestimmter und eingangsseitig zur Synchronisierung mit dem Spannungs-Messsignal gekoppelter Oszillator SU vorgesehen. Das Spannungs-Bezugssignal $u_0$ stellt hier also eine Fortsetzung der ungestörten Spannung über den Fehlereintritt hinaus dar. Die im allgemeinen sprungartige Spannungsänderung beim Kurzschluss erzeugt demgemäss sofort ein vergleichsweise grosses Differenzsignal. Für den Strom- und Spannungs-Messkanal ergibt die Differenzsignalbildung den Vorteil einer hohen Signaldynamik im Vergleich mit einer Detektion, bei der Signalamplituden verwendet werden. Die Bildung des Spannungs-Bezugssignals unter Verwendung eines Oszillators hat dabei den besonderen Vorteil, dass die Bezugsspannung, im Unterschied zur blossen Verzögerung des Spannungs-Messsignals, für eine wiederholte Richtungsdetektion auch nach Ablauf einer Grundschwingungs-Periodendauer verfügbar ist.

Die Auswertung erfolgt wieder in einer Vorzeichenvergleichsschaltung CS. Auch hier ist eine gesonderte Freigabe der Auswerteschaltung in Abhängigkeit von dem Betrag des Strom-Differenzsignals vorgesehen, und zwar in Form eines Betragsvergleichs mit vorgebbaren niedrigen, im allgemeinen nullpunkt-symmetrischen Strom-Grenzwerten $G_1$ und $G_2$. Hierfür ist an die Differenzsignalbildner DI ein entsprechender Grenzwertschalter CD, z. B. ein Schmitt-Trigger, angeschlossen.

Auf diese Weise wird die Vorzeichenauswertung nur dann freigegeben wenn der Betrag $\triangle i$ vorgegebene Werte überschreitet. Damit vermeidet man Unsicherheiten bei der Richtungsdetektion von Kurzschlüssen, wenn $\triangle i$ durch 0 geht, vgl. Fig. 4a und b.

Man kann gegebenenfalls alle Unsicherheits- und Umkehrungsbereiche ausschliessen, indem man die Strom-Grenzwerte $G_1$ und $G_2$ vom Betrage des Spannungsdifferenzsignals $\triangle u$ in gegensinniger Weise abhängig macht, d. h. je kleiner $\triangle u$ ist, desto grösser werden die Strom-Grenzwerte G1 und G2 gewählt. Hierzu ist eine Steuerverbindung zwischen dem Ausgang von DU und entsprechenden Grenzwert-Steuereingängen $g_1$ und $g_2$ von CD erforderlich (in Fig. 3 strichliert angedeutet). In diese Steuerverbindung ist ein Signalwandler SW, der z. B. ein Hyperbelgenerator sein kann, eingefügt, der eine funktionale Zuordnung der Grenzwerte entsprechend der im Schaltungsblock angedeuteten Funktion bewirkt. Dadurch kann zum Beispiel eine Blockierung der Freigabe bei kleineren, störempfindlichen Beträgen des Spannungs-Differenzsignals $\triangle u$ durch Heraufsetzen der Beträge der Strom-Grenzwerte $G_1$ und $G_2$ erzielt werden. Nachdem sich Strom und Spannung bei einem Kurzschluss in Vorwärtsrichtung zueinander gegensinnig ändern, ermöglicht diese Grenzwerteinstellung ein besonders sicheres Freigabekriterium für die Richtungsdetektion.

Der Zeitverlauf der wichtigsten Signale aus der Schaltung nach Fig. 3 ist für einen Kurzschluss in Vorwärtsrichtung V zum Zeitpunkt t an der Kurzschlussstelle K in den Fig. 4a-4d wiedergegeben, und zwar für i, u, $i_0$, $u_0$ und die entsprechenden Differenzsignale $\triangle i$ und $\triangle u$.

Weiterhin kann gemäss der in Fig. 5 angedeuteten Schaltungsvariante die Auswertung der Differenzsignale $\triangle i$ und $\triangle u$ und damit die Fehlerrichtungsdetektion mit einer bestimmten Zeitverzögerung gebenüber dem durch eine besondere Anregung detektierten Fehlereintritt ausgelöst bzw. freigegeben werden. Hierzu ist die Vorzeichenvergleichsschaltung CS mit einem entsprechenden Sperr- und Freigabeeingang über ein Zeitglied Z an den Auslösekanal A angeschlossen. Von der übrigen Schaltung, die mit der Ausführung nach Fig. 1 oder Fig. 3 übereinstimmen kann, sind nur die Trigger $TR_i$ und $TR_u$ für die Vorzeichendetektion der Differenzsignale angedeutet.

Die Erfindung ist auf das in den Zeichnungen Dargestellte selbstverständlich nicht beschränkt. So könnte anstelle der beiden Teilkanäle des Strommesskanals ein einkanaliger Begrenzer für $\pm i_0$ verwendet werden. Anstelle der Trigger $TR_i$, $TR_u$ mit binären Ausgangssignalen können auch Schaltungen mit 3 Ausgangszuständen, z. B. « - 1 », « 0 », und « + 1 », verwendet werden, wobei das 0-Signal dann anliegt, wenn der vorgebbare Grenzwert für den Strom bzw. die Spannung nicht überschritten wurde. Das Verlassen des Zustandes « 0 » entspricht einem Freigabekriterium für die Abgabe eines Kurzschluss-Richtungssignals. Zu diesem Zweck können die Trigger $TR_i$ bzw. $TR_u$ über gestrichelt gezeichnete Leitungen 7 bzw. 8 und die Freigabeleitung 9 mit dem Freigabeeingang der Vorzeichenvergleichsschaltung CS verbunden sein.

## Bezeichnungsliste

A Anregekanal
CD Grenzwertschalter
CS Vorzeichen-Vergleichsschalter
$DI_1$, $DI_2$ Differenzsignalbildner
DI, DU Differenzsignalbildner
$G_1$, $G_2$ Stromgrenzwert

GU Bezugssignalgeber
$I_1$, $I_2$ Teilkanäle des Strommesskanals
$+ i_0$, $- i_0$ Stromgrenzwerte bzw. Strom-Bezugssignale
$\Delta i_1$, $\Delta i_2$ Stromdifferenzsignale
i Strommesssignal
$i_i$, $i_2$ Ausgangssignal von $GI_1$ bzw. $GI_2$
$\tau$ Verzögerungszeitdauer bzw. Zeitverzögerung
K Kurzschlussstelle
SH Abtast- und Speicherschaltung
SU Oszillator
SW Signalwandler
t Zeit
$t_0$ Zeitpunkt des Fehlereintritts
$TR_i$ Trigger - bistabiler Vibrator (Flipflop)
u Spannungs-Messsignal
U Spannungs-Messkanal
$U_0$ Spannungs-Bezugssignal
V Vorwärtsrichtung der Leitung
ZU Verzögerungsschaltung bzw. Zeitverzögerung
1 Stromversorgungsleitung
2 Messstelle
3 Stromwandler
4 Spannungswandler
5 Ausgangssignal von CS für Kurzschluss in Vorwärtsrichtung
6 Ausgangssignal von CS für Kurzschluss in Rückwärtsrichtung
7, 8 Leitungen
9 Freigabeleitung

**Ansprüche**

1. Verfahren zur Kurzschluss-Richtungsdetektion an elektrischen Einrichtungen (1), insbesondere an elektrischen Leitungen und Stromversorgungs-Netzen,

a) bei welchem Verfahren von Strom- und Spannungsmesssignalen (i, u), die von diesen elektrischen Einrichtungen (1) abgeleitet sind, ein Fehlerrichtungskriterium bezüglich eines Messortes (2) erzeugt wird,

b) wobei mindestens ein Stromdifferenzsignal ($\Delta i$) durch Differenzbildung aus dem Strommesssignal (i) und mindestens einem Strom-Bezugssignal ($i_0$) gebildet wird,

c) wobei mindestens ein Spannungsdifferenzsignal ($\Delta u$) durch Differenzbildung aus dem Spannungsmesssignal (u) und einem Spannungs-Bezugssignal ($u_0$) gebildet wird und

d) wobei mindestens eines dieser Bezugssignale ($i_0$, $u_0$) aus dem Zeitverlauf dieser Strom- bzw. Spannungsmesssignale (i bzw. u) abgeleitet wird,
dadurch gekennzeichnet,

e) dass als Strom-Bezugssignal ($i_0$) mindestens ein vorgebbarer Strom-Grenzwert ($|i_0|$) verwendet wird und

f) dass die Zuordnung eines Leitungskurzschlusses zu einer Vorwärtsrichtung (V) bzw. Rückwärtsrichtung in Abhängigkeit von einer Uebereinstimmung bzw. Nichtübereinstimmung der Vorzeichen dieser Strom- und Spannungsdifferenzsignale ($\Delta i$, $\Delta u$) getroffen wird.

2. Verfahren zur Kurzschluss-Richtungsdetektion an elektrischen Einrichtungen (1), insbesondere an elektrischen Leitungen und Stromversorgungs-Netzen,

a) bei welchem Verfahren von Strom- und Spannungsmesssignalen (i, u), die von diesen elektrischen Einrichtungen (1) abgeleitet sind, ein Fehlerrichtungskriterium bezüglich eines Messortes (2) erzeugt wird,

b) wobei mindestens ein Stromdifferenzsignal ($\Delta i$) durch Differenzbildung aus dem Strommesssignal (i) und mindestens einem Strom-Bezugssignal ($i_0$) gebildet wird,

c) wobei mindestens ein Spannungsdifferenzsignal ($\Delta u$) durch Differenzbildung aus dem Spannungsmesssignal (u) und einem Spannungs-Bezugssignal ($u_0$) gebildet wird und

d) wobei mindestens eines dieser Bezugssignale ($i_0$, $u_0$) aus dem Zeitverlauf dieser Strom- bzw. Spannungsmesssignale (i bzw. u) abgeleitet wird,
dadurch gekennzeichnet,

e) dass wenigstens eines der Strom- bzw. Spannungs-Bezugssignale ($i_0$, $u_0$) aus dem Zeitverlauf des Strom- bzw. Spannungsmesssignals (i, u) durch eine vorgebbare Zeitverzögerung ($\tau$) von weniger als einer Grundschwingungshalbperiode abgeleitet wird und

f) dass die Zuordnung eines Leitungskurzschlusses zu einer Vorwärtsrichtung (V) bzw. Rückwärtsrichtung in Abhängigkeit von einer Uebereinstimmung bzw. Nicht-übereinstimmung der Vorzeichen dieser Strom- und Spannungsdifferenzsignale ($\triangle i$, $\triangle u$) getroffen wird.

3. Einrichtung zur Kurzschluss-Richtungsdetektion an elektrischen Einrichtung (1), insbesondere an elektrischen Leitungen und Stromversorgungs-Netzen,

a) mit mindestens einem mit dieser elektrischen Einrichtung (1) in Wirkverbindung stehenden Strom-Messkanal ($I_1$, $I_2$ bzw. I) und mindestens einem Spannungs-Messkanal (U) mit je einem mit dieser elektrischen Einrichtung (1) in Wirkverbindung stehenden Strom- bzw. Spannungs-Bezugssignalgeber ($GI_1$, $GI_2$, bzw. GI ; GU, $GU_s$),

b) mit mindestens je einem eingangsseitig mit diesem Strom- bzw. Spannungsmesskanal und dem jeweils zugehörigen Bezugssignalgeber in Wirkverbindung stehenden Differenzsignalbildner ($DI_1$, $DI_2$ bzw. DI ; DU) zur Erzeugung eines Strom- bzw. Spannungsdifferenzsignals ($\triangle i_1$, $\triangle i_2$ bzw. $\triangle i$ ; $\triangle u$) dadurch gekennzeichnet,

c) dass mindestens einer der Strom- bzw. Spannungs-Bezugssignalgeber (GI, GU, $GU_s$) eine dynamische Speicherschaltung (ZI, ZU, SU) zur Erzeugung eines aus dem Zeitverlauf der Strom- bzw. Spannungsmesssignale (i, u) abgeleiteten Bezugssignals ($i_0$, $u_0$) aufweist,

d) dass diese Differenzsignalbildner der Strom- und Spannungsmesskanäle ausgangsseitig mit einer Vorzeichen-Vergleichsschaltung (CS) für den Vergleich der Vorzeichen dieser Strom- und Spannungdifferenzsignale ($\triangle i_1$, $\triangle i_2$ bzw. $\triangle i$ ; $\triangle u$) in Wirkverbindung stehen, deren Ausgangssignale (5, 6) einen Kurzschluss in Vorwärts- bzw. Rückwärtsrichtung kennzeichnen, und

e) dass ein Freigabeglied ($GS_1$, $GS_2$, GO, CD) vorgesehen ist, das eingangsseitig mit mindestens einem Ausgang der Differenzsignalbildner ($DI_1$, $DI_2$, DI) und ausgangsseitig mit der Vorzeichen-Vergleichsschaltung (CS) in Wirkverbindung steht.

4. Einrichtung nach Anspruch 3, dadurch gekennzeichnet, dass

a) der Strom-Differenzsignalbildner (DI) ausgangsseitig über einen Grenzwertschalter (CD) mit der Vorzeichen-Vergleichsschaltung (CS) in Wirkverbindung steht,

b) dass der Spannungs-Differenzsignalbildner (DU) ausgangsseitig über einen Signalwandler (SW) mit dem Grenzwertschalter (CD) in Wirkverbindung steht und

c) dass mindestens ein Stromgrenzwert ($G_1$, $G_2$) des Grenzwertschalters (CD) in Abhängigkeit vom Ausgangssignal des Signalwandlers einstellbar ist.

**Claims**

1. Method for detecting the direction of a short circuit in electric facilities (1) and particularly in electric lines and power-supply systems,

a) in which method a fault direction criterion with respect to a measurement location (2) is generated from current and voltage measurement signals (i, u) which are derived from these electric facilities (1),

b) in connection with which at least one current difference signal ($\triangle i$) is formed by forming the difference between the current measurement signal (i) and at least one current reference signal ($i_0$),

c) and at least one voltage difference signal ($\triangle u$) being formed by forming the difference between the voltage measurement signal (u) and a voltage reference signal ($u_0$) and

d) at least one of these reference signals ($i_0$, $u_0$) being derived from the variation with time of these current and voltage measurement signals (i and u),

characterised in

e) that at least one predeterminable current limit value ($|i_0|$) is used as the current reference signal ($i_0$) and

f) that a line short circuit is associated with a forward direction (V) or backward direction as a function of an agreement or non-agreement of the signs of these current and voltage difference signals ($\triangle i$, $\triangle u$).

2. Method for detecting the direction of a short circuit in electric facilities (1) and particularly in electric lines and power-supply systems,

a) in which method a fault direction criterion with respect to a measurement location (2) is generated from current and voltage measurement signals (i, u) which are derived from these electric facilities (1),

b) in connection with which at least one current difference signal ($\triangle i$) is formed by forming the difference between the current measurement signal (i) and at least one current reference signal ($i_0$),

c) and at least one voltage difference signal ($\triangle u$) being formed by forming the difference between the voltage measurement signal (u) and a voltage reference signal ($u_0$) and

d) at least one of these reference signals ($i_0$, $u_0$) being derived from the variation with time of these current and voltage measurement signals (i and u),

characterised in

e) that at least one of the current and voltage reference signals ($i_0$, $u_0$) is derived from the variation with time of the current and voltage measurement signal (i, u) by a predeterminable time delay ($\tau$) of less than one half period of the fundamental frequency and

**0 046 317**

f) that a line short circuit is associated with a forward direction (V) or backward direction as a function of an agreement or non-agreement of the signs of these current and voltage difference signals ($\triangle i$, $\triangle u$).

3. Device for detecting the direction of a short circuit in electric facilities (1) and particularly in electric lines and power-supply systems,

a) having at least one current measuring channel ($I_1$, $I_2$, and I) which is effectively connected to this electric facility (1) and having at least one voltage measuring channel (U) including in each case one current and voltage reference signal generator ($GI_1$, $GI_2$ and GI ; GU, $GU_s$) which are effectively connected to this electric facility (1),

b) and having at least one difference-signal former ($DI_1$, $DI_2$ and DI ; DU) each, the input of which is effectively connected to this current and voltage measuring channel and the respective associated reference signal generator, for generating a current and voltage difference signal ($\triangle i_1$, $\triangle i_2$ and $\triangle i$ ; $\triangle u$) characterised in

c) that at least one of the current and voltage reference signal generators (GI, GU, $GU_s$) is provided with a dynamic memory circuit (ZI, ZU, SU) for generating a reference signal ($i_0$, $u_0$) derived from the variation with time of the current and voltage measurement signals (i, u)

d) that these difference-signal formers of the current and voltage measuring channels are effectively connected at the output to a sign comparator circuit (CS) for comparing the signs of these current and voltage difference signals ($\triangle i_1$, $\triangle i_2$ and $\triangle i$ ; $\triangle u$), the output signals (5, 6) of which characterise a short circuit in the forward or backward direction, and

e) that an enabling element ($GS_1$, $GS_2$, GO, CD) is provided which is effectively connected at the output to at least one output of the difference-signal former ($DI_1$, $DI_2$, Di) and at the output to the sign comparator circuit (CS).

4. Device according to Claim 3, characterised in that

a) the output of the current difference-signal former (DI) is effectively connected via a limit switch (CD) to the sign comparator circuit (CS),

b) that the output of the voltage difference signal former (DU) is effectively connected via a signal converter (SW) to the limit switch (CD) and

c) that at least one current limit ($G_1$, $G_2$) of the limit switch (CD) can be set as a function of the output signal of the signal converter.

**Revendications**

1. Procédé pour détecter la direction d'un court-circuit dans des installations électriques (1), en particulier dans des lignes électriques et des réseaux de distribution de courant,

a) dans lequel on produit, à partir de signaux de mesure de courant et de tension (i, u), qui sont dérivés de ces installations électriques (1), un critère de direction du défaut par rapport à un point de mesure (2),

b) dans lequel on forme au moins un signal différentiel de courant ($\triangle i$) en formant la différence entre le signal de mesure du courant (i) et au moins un signal de référence du courant ($i_0$),

c) dans lequel on forme au moins un signal différentiel de tension ($\triangle u$) en formant la différence entre le signal de mesure de la tension (u) et un signal de référence de la tension ($u_0$) et

d) dans lequel au moins un de ces signaux de référence ($i_0$, $u_0$) est déduit de la courbe temporelle de ces signaux de mesure du courant, resp. de la tension (i resp. u),
caractérisé en ce que

e) comme signal de référence du courant ($i_0$) on utilise au moins une valeur-limite prédéterminable du courant ($|i_0|$) et

f) en ce que la localisation d'un court-circuit de ligne dans une direction avant (V) resp. arrière est réalisée en fonction d'une correspondance resp. d'une non-correspondance des signes de ces signaux différentiels de courant et de tension ($\triangle i$, $\triangle u$).

2. Procédé pour détecter la direction d'un court-circuit dans des installations électriques (1), en particulier dans des lignes électriques et des réseaux de distribution de courant,

a) dans lequel on produit, à partir de signaux de mesure de courant et de tension (i, u), qui sont dérivés de ces installations électriques (1), un critère de direction du défaut par rapport à un point de mesure (2),

b) dans lequel on forme au moins un signal différentiel de courant ($\triangle i$) en formant la différence entre le signal de mesure du courant (i) et au moins un signal de référence du courant ($i_0$),

c) dans lequel on forme au moins un signal différentiel de tension ($\triangle u$) en formant la différence entre le signal de mesure de la tension (u) et un signal de référence de la tension ($u_0$), et

d) dans lequel au moins un de ces signaux de référence ($i_0$, $u_0$) est déduit de la courbe temporelle de ces signaux de mesure du courant, resp. de la tension (i, resp. u),
caractérisé en ce que

e) au moins un de ces signaux de référence du courant, resp. de la tension ($i_0$, $u_0$) est déduit de la courbe temporelle du signal de mesure du courant, resp. de la tension (i, u), par un décalage de temps prédéterminable ($\tau$) de moins d'une demi-période de l'oscillation de base, et

7

f) en ce que la localisation d'un court-circuit de ligne dans une direction avant (v) resp. arrière est réalisée en fonction d'une correspondance, resp. d'une non-correspondance des signes de ces signaux différentiels de courant et de tension ($\Delta i$, $\Delta u$).

3. Dispositif pour détecter la direction d'un court-circuit dans des installations électriques (1), en particulier dans des lignes électriques et des réseaux de distribution de courant,

a) comportant au moins un canal de mesure du courant ($I_1$, $I_2$, resp. I) se trouvant en connexion active avec cette installation électrique (1) et au moins un canal de mesure de tension (u) comprenant chacun un émetteur de signal de référence de courant, resp. de tension ($GI_1$, $GI_2$, resp. GI ; GU, $GU_s$) se trouvant en connexion active avec cette installation électrique (1),

b) comportant au moins, chacun, un générateur de signal différentiel ($DI_1$, $DI_2$, resp. DI ; DU) se trouvant en connexion active, du côté entrée, avec ce canal de mesure de courant resp. de tension et avec l'émetteur de signal de référence associé à chacun d'eux, pour la production d'un signal différentiel de courant, resp. de tension ($\Delta i_1$, $\Delta i_2$, resp. $\Delta i$, $\Delta u$),
caractérisé en ce que

c) au moins un des émetteurs de signal de référence de courant resp. de tension (GI, GU, $GU_s$) comporte un circuit de mémoire dynamique (ZI, ZU, SU) pour la production d'un signal de référence ($i_0$, $u_0$) déduit de la courbe temporelle des signaux de mesure du courant, resp. de la tension (i, u),

d) ces générateurs de signal différentiel des canaux de mesure du courant resp. de la tension se trouvent, du côté sortie, en connexion active avec un circuit de comparaison des signes (CS) pour la comparaison des signes de ces signaux différentiels du courant resp. de la tension ($\Delta i_1$, $\Delta i_2$ resp. $\Delta i$ ; $\Delta u$), dont les signaux de sortie (5, 6) caractérisent un court-circuit en aval resp. en amont,

e) un élément de vidage ($GS_1$, $GS_2$, GO, CD) est prévu, qui est en connexion active à l'entrée avec une sortie des générateurs de signal différentiel ($DI_1$, $DI_2$, DI) et à la sortie avec le circuit de comparaison de signes (CD).

4. Dispositif selon la revendication 3, caractérisé en ce que

a) le générateur de signal différentiel de courant (DI) est, à la sortie, en connexion active avec le circuit de comparaison de signes (CS) par l'intermédiaire d'un interrupteur à valeur limite (CD),

b) le générateur de signal différentiel de tension (DU) est, à la sortie, en connexion active avec l'interrupteur à valeur limite (CD) par l'intermédiaire d'un convertisseur de signaux (SW), et

c) au moins une valeur limite du courant ($G_1$, $G_2$) de l'interrupteur à valeur limite (CD) est réglable en fonction du signal de sortie du convertisseur de signaux.

FIG.1

1

FIG.2

**0 046 317**

a)

b)

c)

d)

FIG. 4

3

FIG.3

FIG.5

4